# EUROPÄISCHE PATENTSCHRIFT

(11) **EP 1 277 230 B1**
(45) Veröffentlichungstag und Bekanntmachung des Hinweises auf die Patenterteilung: **01.08.2007**
(21) Anmeldenummer: 01945058.4
(22) Anmeldetag: 27.04.2001
(51) Int. Cl.: H01L 21/02

(54) **VERFAHREN ZUR HERSTELLUNG VON KONDENSATORSTRUKTUREN**
METHOD FOR PRODUCING CAPACITOR STRUCTURES
PROCEDE DE FABRICATION DE STRUCTURES DE CONDENSATEUR

(30) Priorität: 28.04.2000 DE 10022655
(43) Veröffentlichungstag der Anmeldung: 22.01.2003
(73) Patentinhaber: Qimonda AG, 81739 München (DE)
(72) Erfinder: HARTNER, Walter, Glen Allen, VA 23060 (US); SCHNABEL, Rainer, Florian, 85635 Höhenkirchen (DE); SCHINDLER, Günther, 80802 München (DE)
(74) Vertreter: Ginzel, Christian
(86) Internationale Anmeldenummer: PCT/EP2001/004786
(87) Internationale Veröffentlichungsnummer: WO 2001/084605

(56) Entgegenhaltungen:
- EP-A- 0 834 912
- US-A- 5 702 989
- US-A- 5 976 928
- PATENT ABSTRACTS OF JAPAN vol. 1999, no. 03, 31. März 1999 (1999-03-31) & JP 10 340871 A (TOSHIBA CORP), 22. Dezember 1998 (1998-12-22)

## Beschreibung

Die vorliegende Erfindung betrifft ein Verfahren zur Herstellung von Kondensatorstrukturen. Die vorliegende Erfindung betrifft insbesondere ein Verfahren zur Herstellung von ferroelektrischen Kondensatorstrukturen bzw. von Kondensatorstrukturen, deren Dielektrikum eine hohe Dielektrizitätskonstante aufweist.

Um die in einem Speicherkondensator einer Speicherzelle gespeicherte Ladung reproduzierbar auslesen zu können, sollte die Kapazität des Speicherkondensators mindestens einen Wert von etwa 30 fF besitzen. Gleichzeitig muß die laterale Ausdehnung des Kondensators ständig verkleinert werden, um eine Erhöhung der Speicherdichte erzielen zu können. Diese gegenläufigen Anforderungen an den Kondensator der Speicherzellen führen zu einer immer komplexeren Strukturierung des Kondensators ("Trench-Kondensatoren", "Stack-Kondensatoren", "Kronen-Kondensatoren"), um trotz kleiner werdender lateraler Ausdehnung des Kondensators eine ausreichende Kondensatorfläche bereitstellen zu können. Dementsprechend wird die Herstellung des Kondensators immer aufwendiger und damit immer teurer.

Eine andere Möglichkeit, eine ausreichende Kapazität des Kondensators zu gewährleisten, liegt in der Verwendung anderer Materialien für die Dielektrikumsschicht zwischen den Kondensatorelektroden. In letzter Zeit werden daher anstatt des herkömmlichen Siliziumoxids/ Siliziumnitrids neue Materialien, insbesondere hoch-ε Paraelektrika und Ferroelektrika, zwischen den Kondensatorelektroden einer Speicherzelle verwendet. Diese neuen Materialien besitzen eine deutlich höhere relative Dielektrizitätskonstante (> 20) als das herkömmliche Siliziumoxid/Siliziumnitrid (< 8). Daher kann durch den Einsatz dieser Materialien, bei gleicher Kapazität die laterale Ausdehnung der Speicherzelle und die benötigte Kondensatorfläche und damit die benötigte Komplexität der Strukturierung des Kondensators deutlich vermindert werden. Beispielsweise kommen Bariumstrontiumtitanat (BST, (Ba,Sr)TiO₃), Bleizirkonattitanat (PZT, Pb(Zr,Ti)O₃) bzw. Lanthan-dotiertes Bleizirkonattitanat oder Strontiumwismuttantalat (SBT, SrBi₂Ta₂O₉) zum Einsatz.

Neben herkömmlichen DRAM-Speicherbausteinen werden in Zukunft auch ferroelektrische Speicheranordnungen, sogenannte FRAM's, eine wichtige Rolle spielen. Ferroelektrische Speicheranordnungen besitzen gegenüber herkömmlichen Speicheranordnungen, wie beispielsweise DRAMs und SRAMs, den Vorteil, daß die gespeicherte Information auch bei einer Unterbrechung der Spannungs- bzw. Stromversorgung nicht verloren geht sondern gespeichert bleibt. Diese Nichtflüchtigkeit ferroelektrischer Speicheranordnungen beruht auf der Tatsache, daß bei ferroelektrischen Materialien die durch ein äußeres elektrisches Feld eingeprägte Polarisation auch nach Abschalten des äußeren elektrischen Feldes im wesentlichen beibehalten wird. Auch für ferroelektrische Speicheranordnungen kommen die bereits genannten neuen Materialien wie Bleizirkonattitanat (PZT, Pb(Zr,Ti)O₃) bzw. Lanthan-dotiertes Bleizirkonattitanat oder Strontiumwismuttantalat (SBT, SrBi₂Ta₂O₉) zum Einsatz.

Leider sind die hoch-ε Paraelektrika und Ferroelektrika durch herkömmliche Ätzprozesse nur schwer zu strukturieren. Werden diese Materialien für die Herstellung von Dielektrikumsschichten für Speicherkondensatoren verwendet, so bedingen diese Materialien zusätzlich neue Elektrodenmaterialien, die mit den Prozeßschritten zur Abscheidung der neuen Dielektrika verträglich sind. So erfolgt z.B. die Abscheidung der Dielektrika bei hohen Temperaturen, die die auf dem Substrat bereits vorhandenen herkömmlichen Elektrodenmaterialien, z.B. dotiertes Polysilizium, oxidieren und damit nichtleitend machen würden. Letzteres würde zum Ausfall der Speicherzelle führen.

Wegen ihrer guten Oxidationsbeständigkeit und/oder der Ausbildung elektrisch leitfähiger Oxide gelten 4d und 5d Übergangsmetalle, insbesondere Edelmetalle wie Ru, Rh, Pd und Os, und insbesondere Pt, Ir und IrO₂, als aussichtsreiche Kandidaten, die dotierte Silizium/Polysilizium als Elektrodenmaterial ersetzen könnten.

Leider hat sich herausgestellt, daß die oben genannten, in integrierten Schaltungen neu eingesetzten Elektrodenmaterialien zu einer Klasse von Materialien gehören, die sich nur schwer strukturieren lassen. Beispielsweise gehören diese Materialien zu den chemisch nur schwer oder gar nicht ätzbaren Materialien, bei denen der Ätzabtrag, auch bei der Verwendung "reaktiver" Gase, überwiegend oder fast ausschließlich auf dem physikalischen Anteil der Ätzung beruht. Dies hat zur Folge, daß die Ätzkanten nicht steil sind und sehr kleine Strukturen nur schwer herzustellen sind. An den Ätzkanten werden auch oft schwer entfernbare Redepositionen beobachtet.

Ein alternatives Verfahren zur Strukturierung von Schichten kann mit Hilfe des CMP-Prozeßschritts (**C**hemical-**M**echanical **P**olishing, z. B. US 5,976,928) durchgeführt werden. Bei diesem Verfahren wird die Struktur durch eine Maske aus einem photolithographisch leicht strukturierbaren Material, z.B. Siliziumoxid oder Siliziumnitrid, vorgegeben. Es folgt eine Beschichtung mit dem zu strukturierenden Material mit einer Schichtdicke, die mindestens der Dicke der Maske entspricht. Anschließend wird in einem CMP-Schritt das zu strukturierende Material bis auf die Maske herunter abgetragen. Auf diese Weise erhält man eine planare Oberfläche, auf der das zu strukturierende Material die Struktur der offenen Bereiche der Maske angenommen hat.

Das Abtragen mit dem CMP-Prozeßschritt erfolgt durch Polieren mit einem "Pad", das mit definiertem Druck und relativer Geschwindigkeit über das Substrat fährt. Wichtiges Element des CMP-Prozesses ist der Einsatz eines Poliermittels, auch "Slurry" genannt, zwischen Substrat und Pad, das auf das abzutragende Material abgestimmt sein muß. Die Slurry besteht aus einer Lösung, die sowohl abrasive Partikel bestimmter Größe für den mechanischen Abtrag als auch chemische Komponenten, die mit der Schichtoberfläche reagieren und den Abtrag beschleunigen können, enthält.

Bei den neuen Elektrodenmaterialien trägt aufgrund der Inertheit der Materialien die chemische Komponente eines CMP-Schrittes wenig zum Abtrag bei. Der Abtrag erfolgt vor allem durch die mechanische Wirkung der abrasiven Partikel der Slurry. Dementsprechend können diese Materialien nur mit einer geringen Abtragsrate von der Substratoberfläche entfernt werden. Darüber hinaus erhöht sich die Gefahr von Kratzerbildungen, welche die Funktionalität eines Schichtaufbaus zerstören könne. Versuche mit sehr aggressiven chemischen Komponenten in der Slurry führten andererseits nicht zu den gewünschten Ergebnissen.

Eine weitere Einschränkung des standardmäßigen CMP-Prozeßschrittes zur Strukturierung von Schichten liegt darin, daß keine konforme Beschichtung möglich ist, wenn das Substrat in den offenen Maskenbereichen eine Struktur in vertikaler Richtung aufweist. Genau dies ist aber der Standard bei hochintegrerten Speicherbauelementen, da die unteren Elektroden, um eine maximale Kapazität bei minimaler lateraler Ausdehnung zu erhalten, in drei Dimenensionen strukturiert sind.

Die Strukturierung von Schichten mit dem gängigen CMP-Verfahren hat im Hinblick auf die Herstellung von hochintegrierten Speicherbauelementen daher mehrere Schwierigkeiten: a) durch den gegebenenfalls hohen Anteil mechanischem Abriebs während eines herkömmlichen CMP-Schrittes, der beispielsweise bei den chemisch inerten Materialien erforderlich ist, kann die Oberfläche am Ende Kratzer aufweisen, die eine dünne Schicht, insbesondere ein Dielektrikum, schädigen und einen Kondensator damit zerstören können; b) die Oberfläche der zu strukturierenden Schicht kann bei einem herkömmlichen CMP-Schritt durch die Slurry und den Abrieb irreversibel verunreinigt werden; und c) herkömmliche CMP-Strukturierungsverfahren können keine zum Substrat konforme, strukturierte Schicht herstellen, insbesondere wenn das Substrat im Bereich der Maskenöffnungen vertikale Strukturen aufweist.

Das Dokument US 5,976,928 offenbart ein Verfahren zur Herstellung von ferroelektrischen Speicherkondensatoren, bei denen die untere Elektrode, die ferroelektrische Schicht und die obere Elektrode gleichzeitig durch einen einzigen CMP-Schritt strukturiert werden. Dazu werden beispielsweise eine erste Edelmetallschicht, eine ferroelektrische Schicht und eine zweite Edelmetallschicht auf einer isolierenden Schicht, welche Vertiefungen aufweist, abgeschieden und durch einen einzigen CMP-Schritt alle Bereiche dieser Schichten außerhalb der Vertiefungen entfernt. Aufgrund des CMP-Schritts können sich jedoch an den Oberkanten der Vertiefungen elektrisch leitende Verbindungen zwischen den beiden Edelmetallschichten bilden, die somit die beiden Elektroden des Kondensators kurzschließen was zum Ausfall des Speicherkondensators führt.

Aus EP 0 771 022 A2 ist ein Verfahren zur Herstellung eines Kondensators für eine analoge Schaltung bekannt, bei dem die obere Elektrode des Kondensators mittels sog. Damascene-Technik hergestellt wird. Dabei wird in einer auf die untere Elektrode und das Kondensatordielektrikum aufgebrachten Isolationsschicht eine Öffnung geschaffen, in der das Kondensatordielektrikum freiliegt. Diese Öffnung wird nachfolgend vollständig mit dem Material der oberen Elektrode aufgefüllt und bis zur Oberfläche der Isolationsschicht zurückpoliert.

Die JP 7-022 518 A beschreibt ein Verfahren zur Herstellung eines Speicherkondensators, bei dem die untere und die obere Elektrode jeweils durch seperate Damascene-Techniken hergestellt werden. Das dazwischen liegende Kondensatordielektrikum wird ohne Strukturierung abgeschieden.

Der vorliegenden Erfindung liegt die Aufgabe zugrunde, ein Verfahren zur Herstellung von Kondensatorstrukturen anzugeben, das die Nachteile der herkömmlichen Verfahren vermindert bzw. ganz vermeidet. Insbesondere ist es die Aufgabe der vorliegenden Erfindung, ein Verfahren zur Herstellung von Kondensatorstrukturen anzugeben, das es ermöglicht, ferroelektrische Kondensatorstrukturen bzw. Kondensatorstrukturen, deren Dielektrikum eine hohe Dielektrizitätskonstante aufweist, auf kostengünstige Weise herzustellen.

Diese Aufgabe wird von dem Verfahren zur Herstellung zumindest einer Kondensatorstruktur gemäß des unabhängigen Patentanspruchs 1 gelöst. Weitere vorteilhafte Ausführungsformen, Ausgestaltungen und Aspekte der vorliegenden Erfindung ergeben sich aus den abhängigen Patentansprüchen, der Beschreibung und den beiliegenden Zeichnungen.

Erfindungsgemäß wird ein Verfahren zur Herstellung zumindest einer Kondensatorstruktur mit den folgenden Schritten bereitgestellt:
a) ein Substrat wird bereitgestellt,
b) eine erste Elektrode wird auf dem Substrat erzeugt,
c) eine Maske wird erzeugt, wobei die erste Elektrode in einer Öffnung der Maske angeordnet ist,
d) zumindest eine dielektrische Schicht und zumindest eine leitende Schicht für eine zweiten Elektrode werden aufgebracht, wobei die Oberfläche des Teils der leitenden Schicht, der in der Öffnung der Maske aufgebracht wird, im wesentlichen unterhalb der Oberfläche der Maske angeordnet ist, und
a) durch Polieren werden die leitende Schicht und die dielektrische Schicht von der Oberfläche der Maske entfernt, so daß eine Kondensatorstruktur erzeugt wird.

Das erfindungsgemäße Verfahren besitzt den Vorteil, daß die leitende Schicht mit Hilfe der Maske strukturiert wird, ohne daß der zurückbleibende, strukturierte Bereich der leitenden Schicht, der später die obere Elektrode bildet, in Kontakt mit dem polierenden Gegenstand gekommen ist. Dies liegt in der Tatsache begründet, daß die Maske, deren Oberkante höher liegt als die Oberkante der zu strukturierenden Schicht in den göffneten Maskenbereichen, die zurückbleibenden Bereiche der leitenden Schicht schützt. Gleichzeitig bleibt gegebenenfalls ein zum Substrat konformer Schichtverlauf in den geöffneten Maskenbereichen erhalten, was beispielsweise für die Herstellung von Speicherkondensators mit sehr dünnen Dielektrikumschichten vorteilhaft ist.

Durch das erfindungsgemäße Verfahren lassen sich insbesondere solche Materialien strukturieren und damit in Kondensatorstrukturen verwenden, die mit herkömmlichen Ätzverfahren nur schwer strukturiert werden können, insbesondere paraelektrische und ferroelektrische hoch-ε Materialien, sowie Edelmetalle und deren elektrisch leitenden Oxide. Weiterhin ermöglicht das erfindungsgemäße Verfahren die Herstellung von Kondensatorstrukturen mit einer sehr dünnen Dielektrikumsschicht und daher mit einer relativ großen Kapazität. Da der zwischen den Elektroden liegende Bereich der dünnen Dielektrikumsschicht keinen mechanischen Kontakt mit dem Poliergegenstand hat, besteht keine Gefahr, daß dieser Teil der Schicht mechanisch verletzt wird und sich ein Kurzschluß zwischen den zwei Elektrodenschichten des Kondensators bildet.

Bei dem erfindungsgemäßen Verfahren ist die erste (untere) Elektrode bereits strukturiert bevor die dielektrische Schicht und die leitenden Schicht für die zweite (obere) Elektrode aufgebracht werden. Dementsprechend werden durch das Polieren nur die dielektrische Schicht und die leitenden Schicht für die zweite Elektrode strukturiert. Eine Ausbildung von leitenden Verbindung zwischen der ersten und der zweiten Elektrode durch das Polieren ist damit ausgeschlossen.

Bevorzugt wird vor dem Polierschritt eine Füllschicht auf die leitende Schicht aufgebracht. Mit dieser Anordnung wird die leitende Schicht vor Verunreinigungen, die während des Polierschrittes durch Abtrag und durch das Poliermittel selbst entstehen können, geschützt. Gleichzeitig stützt die Füllschicht die Maskenstruktur während des Polierens gegen mechanische Scherkräfte.

Bevorzugt wird nach dem Polierprozeß eine Deckschicht, insbesondere eine isolierende Deckschicht, auf das Substrat aufgebracht, um die offenen Kanten der leitende Schicht, die an den Rändern der Masken übriggeblieben sind, abzudecken.

Weiterhin ist es bevorzugt, wenn die Maske zwei oder mehrere Schichten umfaßt. Dadurch läßt sich über den gesamten Herstellungsprozeß ein sehr effizienter Prozeßverlauf gewährleisten. Im Ausführungsbeispiel 1 ist z.B. die Oxidschicht 9 zunächst Maske für die Strukturierung der unteren Elektroden (siehe Fig. 6 und Fig. 7) und später zusammen mit der Schicht 11 Maske für die Strukturierung der Schichten 13 und 14 (siehe Fig.10, 11 und 12).

Weiterhin ist es bevorzugt, wenn das Material der dielektrischen Schicht ein Dielektrikum mit einer hohen Dielektrizitätskonstante, eine ferroelektrische Schicht bzw. die Vorstufe einer ferroelektrischen Schicht enthält. Bevorzugt sind insbesondere SBT, PZT oder BST. Darüber hinaus ist es bevorzugt, wenn das Material der leitenden Schicht ein Edelmetall, insbesondere Pt oder Ir, oder ein Oxid eines Edelmetalls enthält.

Bevorzugter Polierprozeßschritt ist der CMP-Schritt (**C**hemical-**M**echanical **P**olishing), d.h. ein Polieren mit einem Poliergegenstand (Pad) und einem Poliermittel (Slurry), das die zu strukturierenden Schichten sowohl durch chemische Reaktionen als auch durch mechanisches Schleifen mit Slurry-Partikeln bestimmter Größe abträgt. Dabei ist es bevorzugt, wenn für jede zu polierende Schicht ein an die zu polierende Schicht angepaßter CMP-Schritt durchgeführt wird

Gemäß einer bevorzugten Ausführungsform enthält die erste Elektrode ein Edelmetall, insbesondere Pt oder Ir, oder ein leitendes Oxid eines Edelmetalls. Weiterhin ist es bevorzugt, wenn erste Elektrode erzeugt wird, indem eine leitende Schicht aufgebracht und durch Polieren strukturiert wird. Auf diese Weise kann im wesentlichen die gesamte Kondensatorstruktur ohne Ätzverfahren und den damit verbundenen Problemen erzeugt werden. Dabei ist es insbesondere bevorzugt, wenn die leitende Schicht für die erste Elektrode konform auf ein entsprechend vorbereitetes Substrat aufgebracht wird. Weiterhin ist es bevorzugt, wenn die dielektrische Schicht und die leitende Schicht für die zweite Elektrode konform aufgebracht werden. Auf diese Weise lassen sich auf einfache Weise Kondensatorstrukturen mit relativ großen Obeflächen erzeugen. Insbesondere ist es bevorzugt, wenn die dielektrische Schicht durch ein CVD-Verfahren aufgebracht wird.

Bevorzugte Materialien für die Maske sind solche, die sich mit photolithographischen Ätzverfahren präzise strukturieren lassen und mit dem Gesamtprozess kompatibel sind, wie z.B. Siliziumoxid oder Siliziumnitrid.

Bevorzugte Füllschichtmaterialien gemäß einer Ausführungsform sind isolierende Materialien, vorzugsweise solche, die mit herkömmlichen CMP-Prozeßschritten abgetragen werden können, wie z.B. Siliziumoxid.

Die Erfindung wird nachfolgend anhand von Figuren der Zeichnung näher dargestellt. Es zeigen:

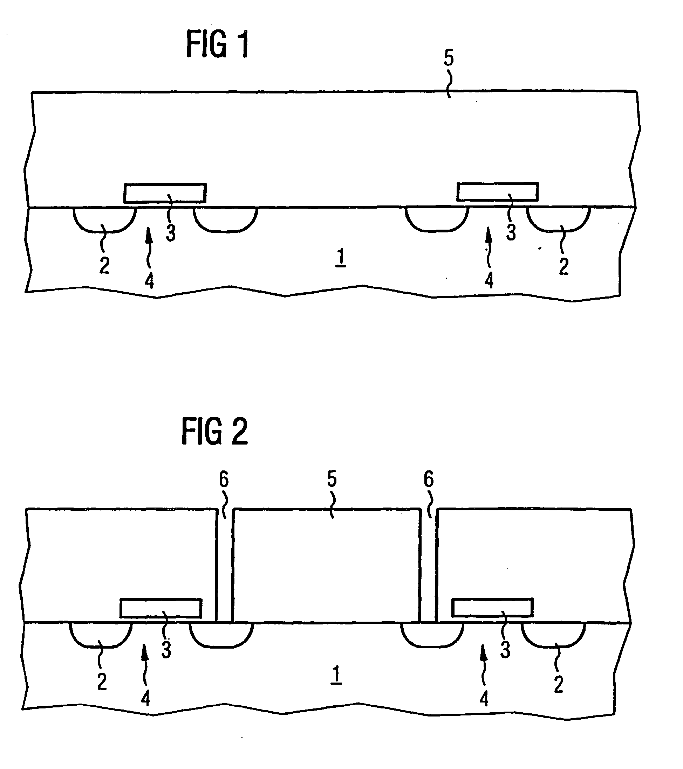

- Fig. 1 - 10: ein Verfahren zur Herstellung von Speicherkondensatoren gemäß einer ersten Ausführungsform der vorliegenden Erfindung,

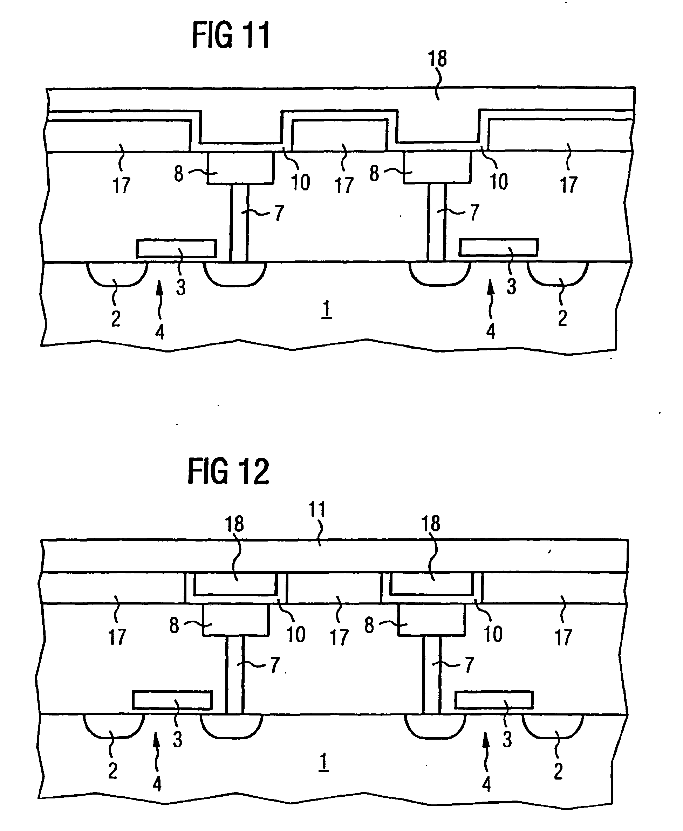

- Fig. 11 - 16: ein Verfahren zur Herstellung von Speicherkondensatoren gemäß einer zweiten Ausführungsform der vorliegenden Erfindung.

Fig. 1 zeigt ein Siliziumsubstrat 1 mit bereits fertiggestellten Transistoren 4. Die Transistoren bilden mit den noch herzustellenden Speicherkondensatoren die Speicherzellen, die der Speicherung der binären Informationen dienen. Die Transistoren 4 weisen jeweils zwei Diffusionsgebiete 2 auf, welche an der Oberfläche des Siliziumsubtrats 1 angeordnet sind. Zwischen den Diffusionsgebieten 2 der Transistoren 4 sind die Kanalzonen angeordnet, die durch das Gateoxid von den Gateelektroden 3 auf der Oberfläche des Siliziumsubstrats 1 getrennt sind. Die Transistoren 4 werden nach den im Stand der Technik bekannten Verfahren hergestellt, die hier nicht näher erläutert werden.

Auf das Siliziumsubtrat 1 mit den Transistoren 4 wird eine isolierende Schicht 5, beispielsweise eine SiO₂-Schicht aufgebracht. In Abhängigkeit des für die Herstellung der Transistoren 4 verwendeten Verfahrens können auch mehrere isolierende Schichten aufgebracht werden. Die sich daraus ergebende Struktur ist in Fig. 1 gezeigt.

Anschließend werden durch eine Phototechnik die Kontaktlöcher 6 erzeugt. Diese Kontaktlöcher 6 stellen eine Verbindung zwischen den Transistoren 4 und den noch zu erzeugenden Speicherkondensatoren her. Die Kontaktlöcher 6 werden beispielsweise durch eine anisotrope Ätzung mit fluorhaltigen Gasen erzeugt. Die sich daraus ergebende Struktur ist in Fig. 2 gezeigt.

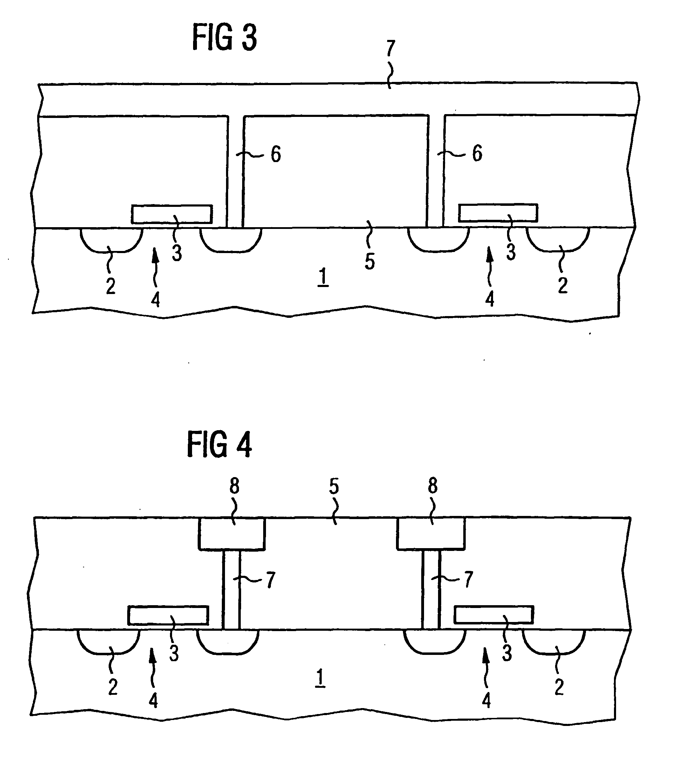

Nachfolgend wird ein leitfähiges Material 7, beispielsweise insitu dotiertes Polysilizium, auf die Struktur aufgebracht. Dies kann beispielsweise durch ein CVD-Verfahren geschehen. Durch das Aufbringen des leitfähigen Materials 7 werden die Kontaktlöcher 6 vollständig ausgefüllt und es entsteht eine zusammenhängende leitfähige Schicht auf der isolierenden Schicht 5 (Fig. 3). Anschließend folgt ein CMP-Schritt, der die zusammenhängende leitfähige Schicht auf der Oberfläche der isolierenden Schicht 5 entfernt und eine ebene Oberfläche erzeugt.

Im weiteren werden Vertiefungen in der isolierenden Schicht 5 überlappend zu den Kontaktlöchern 6 oder nur in den Kontaktlöchern 6 gebildet. Als Alternative können Vertiefungen auch in einer weiteren isolierenden Schicht (nicht gezeigt) erzeugt werden, die nach der Strukturierung des leitfähigen Materials 7 auf die isolierende Schicht 5 abgeschieden wird. Diese Vertiefungen werden nun mit Barrierematerial 8, beispielsweise Iridiumoxid, bis zu einer vorgegebenen Höhe gefüllt. Dies geschieht, indem das Barrierematerial 8 ganzflächig abgeschieden und mit einem CMP-Schritt bis zur Oberfläche der isolierenden Schicht 5 zurückpoliert wird. Die Strukturierung des Barrierematerials 8 kann auch durch eine anisotrope Ätzung erfolgen. Geeignete CMP-Verfahren sind beispielsweise in der am gleichen Tag eingereichten deutschen Patentanmeldung mit dem internen Aktenzeichen GR 00 P 4087 DE mit dem Titel "Polierflüssigkeit und Verfahren zur Strukturierung von Metalloxiden" beschrieben. Die sich daraus ergebende Struktur ist in Fig. 4 gezeigt.

Damit ist der erste Schritt a) des erfindungsgemäßen Verfahrens abgeschlossen, d.h. ein Substrat, auf dem im folgenden eine Kondensatorstruktur erzeugt wird, wurde bereitgestellt

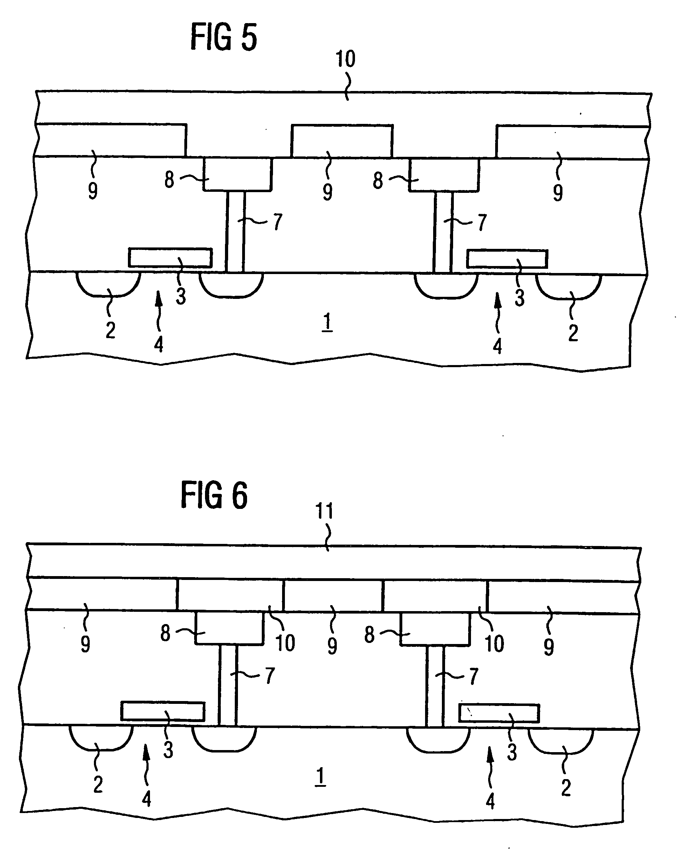

Anschließend wird eine Maskenschicht aus isolierendem Material, z.B. aus Siliziumoxid, aufgebracht und durch einen photolithographischen Schritt so strukturiert, daß sie im Bereich um die Kontaktlöcher geöffnet wird. Die göffneten Bereiche der Maske 9 legen die Geometrie der unteren Elektroden fest. Auf die Siliziumoxid-Maske 9 wird nun eine leitende Schicht 10, beispielsweise eine Pt-Schicht, abgeschieden. Die Dicke der leitenden Schicht ist dabei so gewählt, daß die Öffnungen in der Siliziumoxid-Maske 9 vollständig aufgefüllt werden. Die sich daraus ergebende Struktur ist in Fig. 5 gezeigt.

In einem anschließenden CMP-Schritt wird die zusammenhängende Pt-Schicht 10 auf der Oberfläche der Siliziumoxid-Maske 9 entfernt und eine ebene Oberfläche erzeugt. Damit ist auch der zweite Schritt b) des erfindungsgemäßen Verfahrens abgeschlossen, d.h. eine erste Elektrode wurde auf dem Substrat erzeugt.

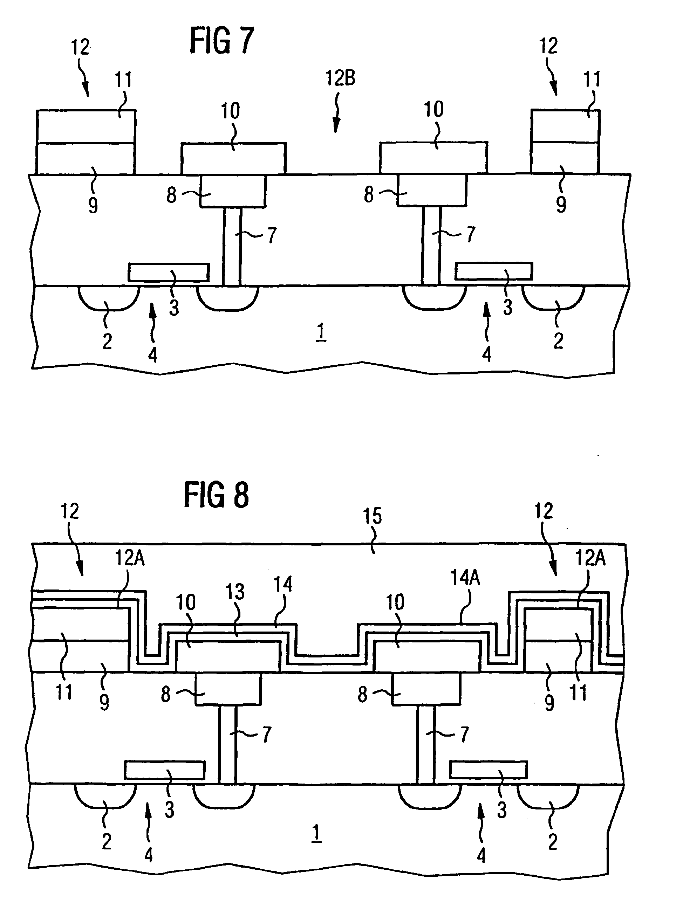

Für die nachfolgende Strukturierung des Speicherdielektrikums sowie der oberen Elektrode wird eine weitere Siliziumoxid-Schicht 11 aufgebracht (Fig. 6). Anschließend werden durch eine Phototechnik die Siliziumoxid-Schicht 11 und die noch verbliebene Siliziumoxid-Maske 9 zur Erzeugung der Maske 12 strukturiert. Die Strukturierung der Siliziumoxid-Schicht 11 und der noch verbliebene Siliziumoxid-Maske 9 ist dabei so ausgelegt, daß die unteren Elektroden in den Öffnungen 12B der Maske 12 reliefartig hervorstehen. Damit ist der Schritt c) des erfindungsgemäßen Verfahrens abgeschlossen. Durch die dreidimensionale Formung der unteren Elektrode ist die Oberfläche der Elektrode vergrößert, was eine Kapazitätserhöhung der Speicherkondensatoren zur Folge hat. Die sich daraus ergebende Struktur ist in Fig. 7 gezeigt.

Es folgt die Abscheidung des Materials für eine ferroelektrische Schicht 13, beispielsweise für eine Schicht aus Strontiumwismuttalantat (SBT). Eine derartige SBT-Schicht wird mit Hilfe eines CVD Prozesses auf das Substrat mit den Elektroden 10 und die Maske 12 abgeschieden. Der CVD Prozeß wird bei einer Substrattemperatur von 385°C und einem Kammerdruck von etwa 1200 Pa durchgeführt. Der Sauerstoffanteil im Gasgemisch beträgt 60%. Dabei wird der SBT Film als amorpher Film abgeschieden. Dementsprechend zeigt der SBT Film im wesentlichen noch keine ferroelektrischen Eigenschaften. Anschließend wird das abgeschiedene, amorphe SBT bei einer Temperatur zwischen 600 bis 750°C für 10 bis 30 min in einer Sauerstoffatmosphäre getempert, wodurch die ferroelektrischen Eigenschaften des SBT erzeugt werden.

Es folgt die Abscheidung einer zweiten leitenden Schicht 14, hier wiederum eine Pt-Schicht. Die Abscheidungsschritte werden mit einer Technologie, die dem Stand der Technik entspricht, durchgeführt. Die übereinander liegenden Schichten 13 und 14 werden konform zu dem Substrat sowie der Maske 12 abgeschieden und sie sind dünn genug, daß die Oberfläche 14A des Teils der zu strukturierenden Schichten 13 und 14, der in der Öffnung 12B der Maske 12 aufgebracht wird, im wesentlichen unterhalb der Oberfläche 12A der Maske 12 angeordnet ist. Damit ist der Schritt d) des erfindungsgemäßen Verfahrens abgeschlossen.

Bei der vorliegenden Ausführungsform der Erfindung wird als nächstes eine Füllschicht 15, beispielsweise aus Siliziumoxid, aufgebracht. Die Dicke dieser Füllschicht 15 ist dabei so gewählt, daß die verbliebenen Öffnungen der Maske vollständig aufgefüllt werden. Die sich daraus ergebende Struktur ist in Fig. 8 gezeigt.

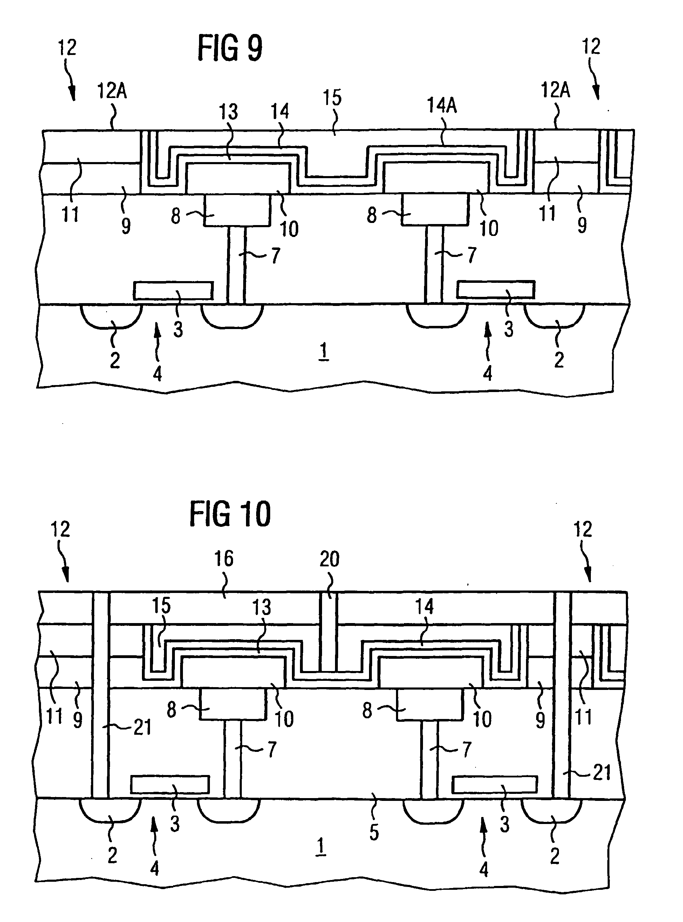

Es folgen drei jeweils an das abzutragende Material angepaßte CMP-Prozeßschritte, wobei ein erster CMP-Schritt, die Füllschicht 15 abträgt, ein weiterer CMP-Schritt den Teil der Pt-Schicht 14, der auf der Maske 12 angeordnet ist, entfernt und ein dritter CMP-Schritt, den Teil der ferroelektrischen Schicht 13, der auf der Maske 12 angeordnet ist, entfernt. Somit wurde eine Kondensatorstruktur mit der ersten Elektrode 10, der dielektrischen (ferroelektrischen) Schicht 13 und der zweiten Elektrode 14 gemäß Schritt e) des erfindungsgemäßen Verfahrens erzeugt. Aufgrund der Füllschicht 15 erfolgt die Strukturierung, ohne daß die verbliebenen Teile der Schichten 13 und 14, die zum aktiven Teil des Kondensators gehören, mit Pad und Slurry während der CMP-Schritte in Berührung gekommen sind. Dementsprechend sind verbliebenen Teile der Schichten 13 und 14 vor Schadigungen bzw. Verunreinigungen geschützt. Die sich daraus ergebende Situation ist in Fig. 9 gezeigt.

Lediglich die Kanten der Schichten 13 und 14 sind noch am Rand der Maske sichtbar. Um die Elektrodenschicht 14 von neuen Leiterbahnebenen elektrisch zu isolieren, wird die leitende Schicht 14 durch eine isolierende Deckschicht 16, beispielsweise Siliziumoxid, abgedeckt.

Um die obere Elektrode 14 und die unter der isolierenden Schicht 5 liegenden Diffusionsgebiete 2 der Transistoren 4 elektrisch zu kontaktieren, werden nun die entsprechenden Kontaktlöcher durch die verschiedenen Siliziumoxid-Schichten 16, 15, 11, 9 und 5 geätzt. Dabei endet mindestens ein Kontaktloch 20 auf der oberen Pt-Elektrode 14; weitere Kontaktlöcher 21 gehen durch die Maske 12, an den Pt-SBT-Schichten vorbei, bis zu den Diffusionsgebieten 2 der Auswahltransistoren 4. Es folgt die Abscheidung einer weiteren leitenden Schicht, so daß die Kontaklöcher auffüllt werden (Fig. 10). Danach werden in herkömmlicher Weise die Metallisierungsebenen und die Passivierung des Bauelements erzeugt.

Eine zweite Ausführung des erfindungsgemäßen Verfahrens ist in den Figuren 11 bis 16 veranschaulicht. Die ersten Schritte des Verfahrens gemäß der zweiten Ausführungsform der vorliegenden Erfindung entsprechen dabei dem, was in Zusammenhang mit den Figuren 1 bis 4 erläutert wurde, so daß auf eine Wiederholung verzichtet werden kann. Wie in Fig. 4 gezeigt, wird ein Substrat, das die isolierende Schicht 5 und die Barrieren 8 umfaßt, bereitgestellt. Damit ist der erste Schritt a) des erfindungsgemäßen Verfahrens abgeschlossen. Ausgehend von dem in Fig. 4 gezeigten Substrat wird eine Maske 17, beispielsweise aus Siliziumoxid, mit einer vorgegeben Dicke auf das Substrat aufgebracht.

Nachfolgend wird auf das Substrat und die Maske 17 eine leitende Elektrodenschicht 10, hier aus Pt, im wesentlichen konform abgeschieden. Die Dicke der Pt-Schicht 10 ist dabei geringer als die Dicke der Maske 17. Dabei ist die Oberfläche des Teils der zu strukturierenden Schicht 10, der auf das Substrat aufgebracht wird, im wesentlichen unterhalb der Oberfläche der Maske 17 angeordnet.

Es folgt das Auftragen einer isolierenden Füllschicht 18, beispielsweise Siliziumoxid, mit einer Dicke, die ausreicht, um die Öffnungen der Maske 17 und der Pt-Schicht 10 auszufüllen. Die sich daraus ergebende Situation ist in Fig. 11 gezeigt.

Es folgt ein CMP-Prozeßschritt, wobei der Teil der Pt-Schicht 10, der auf der Maske 17 angeordnet ist, entfernt wird. Aufgrund der Füllschicht 18 erfolgt die Strukturierung der Pt-Schicht 10, ohne daß die verbliebenen Teile der Schicht 10 mit dem Pad oder der Slurry während des CMP-Schrittes in Berührung gekommen ist. Dementsprechend sind die verbliebenen Teile der Schicht 10 vor Schädigungen bzw. Verunreinigungen geschützt. Damit ist der zweite Schritt b) des erfindungsgemäßen Verfahrens abgeschlossen wodurch die erste Elektrode, in einer Kronengeometrie, fertiggestellt wurde.

Im Folgenden wird nun eine weitere Siliziumoxidschicht 11 aufgebracht. Die sich daraus ergebende Situation ist in Fig. 12 gezeigt.

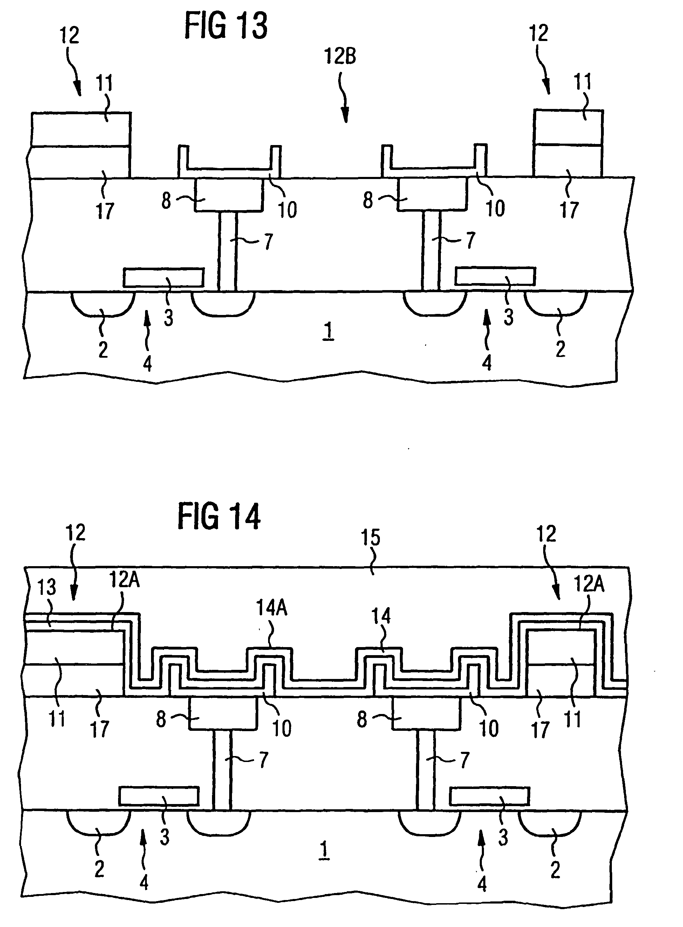

Anschließend werden durch eine Phototechnik die Siliziumoxid-Schicht 11 und die Siliziumoxid-Maske 17 zur Erzeugung der Maske 12 strukturiert. Die Strukturierung der Siliziumoxid-Schicht 11 und der Siliziumoxid-Maske 17 ist dabei wiederum so ausgelegt, daß die unteren Kronenelektroden in der Öffnung 12B der Maske 12 hervorstehen. Damit ist der dritte Schritt c) des erfindungsgemäßen Verfahrens abgeschlossen. Durch die dreidimensionale Formung der unteren Elektrode ist die Oberfläche der Elektrode vergrößert, was eine Kapazitätserhöhung der Speicherkondensatoren zur Folge hat. Die sich daraus ergebende Struktur ist in Fig. 13 gezeigt.

Es folgt die Abscheidung des Materials für eine ferroelektrische Schicht 13, beispielsweise für eine Schicht aus Strontiumwismuttalantat (SBT), sowie die Abscheidung einer zweiten leitenden Schicht 14, hier wiederum eine Pt-Schicht. Die Abscheidungsschritte werden mit einer Technologie, die dem Stand der Technik entspricht, durchgeführt. Die übereinander liegenden Schichten 13 und 14 werden konform zu dem Substrat sowie der Maske 12 abgeschieden und sie sind wiederum dünn genug, daß die Oberfläche 14A des Teils der zu strukturierenden Schichten 13 und 14, der auf das Substrat aufgebracht wird, im wesentlichen unterhalb der Oberfläche 12A der Maske 12 angeordnet ist. Damit ist der Schritt d) des erfindungsgemäßen Verfahrens abgeschlossen.

Wie bei der ersten Ausführungsform der Erfindung wird als nächstes eine Füllschicht 15, beispielsweise aus Siliziumoxid, aufgebracht. Die Dicke dieser Füllschicht 15 ist dabei so gewählt, daß die verbliebenen Öffnungen der Maske vollständig aufgefüllt werden. Die sich daraus ergebende Struktur ist in Fig. 14 gezeigt.

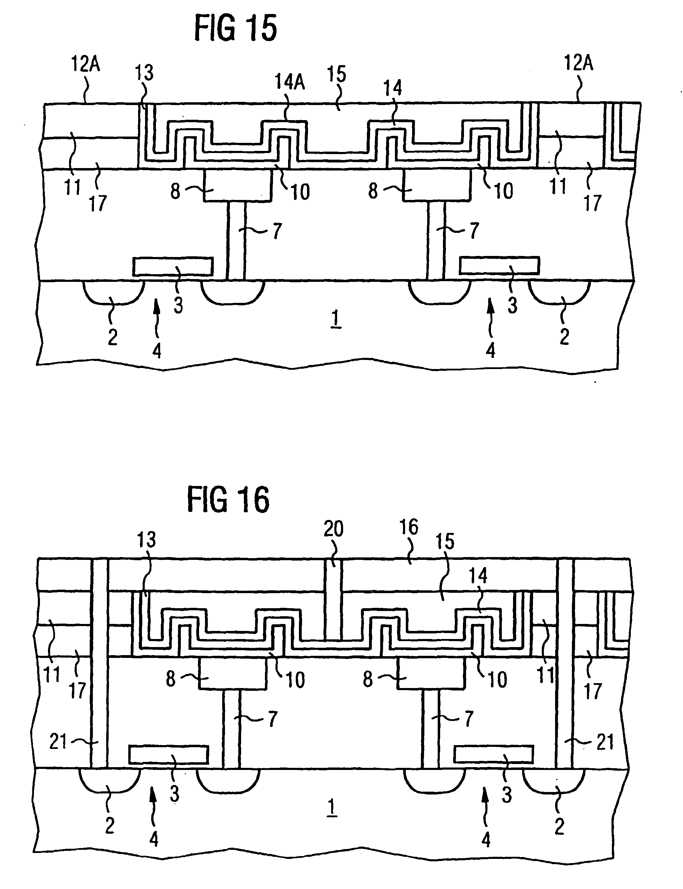

Es folgen drei jeweils an das abzutragende Material angepaßte CMP-Prozeßschritte, wobei ein erster CMP-Schritt, die Füllschicht 15 abträgt, ein weiterer CMP-Schritt den Teil der Pt-Schicht 14, der auf der Maske 12 angeordnet ist, entfernt und ein dritter CMP-Schritt, den Teil der ferroelektrischen Schicht 13, der auf der Maske 12 angeordnet ist, entfernt. Aufgrund der Füllschicht 15 erfolgt die Strukturierung, ohne daß die verbliebenen Teile der Schichten 13 und 14, die den aktiven Teil des Kondensators bilden, mit Pad und Slurry während der CMP-Schritte in Berührung gekommen sind. Dementsprechend sind die verbliebenen Teile der Schichten 13 und 14 vor Schädigungen bzw. Verunreinigungen geschützt. Somit wurde eine Kondensatorstruktur mit der ersten Elektrode 10, der dielektrischen (ferroelektrischen) Schicht 13 und der zweiten Elektrode 14 gemäß Schritt e) des erfindungsgemäßen Verfahrens erzeugt. Die sich daraus ergebende Situation ist in Fig. 15 gezeigt.

Um die Elektrodenschicht 14 von neuen Leiterbahnebenen elektrisch zu isolieren, wird die leitende Schicht 14 durch eine isolierende Deckschicht 16, beispielsweise Siliziumoxid, abgedeckt. Nachfolgend werden, um die obere Elektrode 14 und die unter der isolierenden Schicht 5 liegenden Diffusionsgebiete 2 der Transistoren 4 elektrisch zu kontaktieren, entsprechende Kontaktlöcher durch die verschiedenen Siliziumoxid-Schichten 16, 15, 11, 17 und 5 geätzt. Dabei endet mindestens ein Kontaktloch 20 auf der oberen Pt-Elektrode 14; weitere Kontaktlöcher 21 gehen durch die Maske 12, an den Pt-SBT-Schichten vorbei, bis zu den Diffusionsgebieten 2 der Auswahltransistoren 4. Es folgt die Abscheidung einer weiteren leitenden Schicht, so daß die Kontaklöcher auffüllt werden (Fig. 10). Danach werden in herkömmlicher Weise die Metallisierungsebenen und die Passivierung des Bauelements erzeugt.

Vorteilhaft hierbei ist, daß die weiteren Kontaktlöcher 21 die Ebene der oberen Pt-Elektrode 14 und der dielektrischen Schicht 13 an der Stelle der Maske 12 durchstoßen, ohne die Pt-Elektrode und die dielektrische Schicht 13 freizulegen. Aufgrund des erfindungsgemäßen Verfahrens wurden gerade dort zuvor diese Schichten entfernt. Bei der Ätzung der weiteren Kontaktlöcher 21 verbleiben die Schicht der Pt-Elektrode 14 und der dielektrischen (ferroelektrischen Schicht) 13 eingebettet von der Maske 17 und der SiO₂-Schicht 16, so daß insbesondere die dielektrische Schicht 13 durch die Kontaktlochätzung nicht beschädigt werden kann.

### Bezugszeichenliste

- 1: Siliziumsubstrat
- 2: Diffusionsgebiet
- 3: Gateelektrode
- 4: Auswahltransistor
- 5: SiO₂-Schicht
- 6: Kontaktloch
- 7: Polysiliziumschicht
- 8: Barriere
- 9: Maske
- 10: Edelmetallschicht
- 11: SiO₂-Schicht
- 12: Maske 12A: Oberfläche der Maske
- 13: ferroelektrische Schicht
- 14: Edelmetallschicht 14A: Oberfläche der Edelmetallschicht
- 15: Füllschicht
- 16: SiO₂-Schicht
- 17: Maske
- 18: Füllschicht
- 19 20: Kontaktloch
- 21: Kontaktloch

## Patentansprüche

1. Verfahren zur Herstellung zumindest einer Kondensatorstruktur, mit den folgenden Schritten in der angegebenen Reihenfolge
a) ein Substrat (1) wird bereitgestellt,
b) zumindest eine erste Elektrode (10) wird auf dem Substrat (1) erzeugt,
c) eine Maske (12) wird erzeugt, wobei die erste Elektrode (10) in einer Öffnung der Maske (12) angeordnet ist,
d) zumindest eine dielektrische Schicht (13) und zumindest eine leitende Schicht (14) für eine zweiten Elektrode werden aufgebracht, wobei die Oberfläche (14A) des Teils der leitenden Schicht (14), der in der Öffnung der Maske (12) aufgebracht wird, im wesentlichen unterhalb der Oberfläche (12A) der Maske (12) angeordnet ist, und
e) durch Polieren werden die leitende Schicht (14) und die dielektrische Schicht (13) von der Oberfläche (12A) der Maske (12) entfernt, so daß eine Kondensatorstruktur erzeugt wird.

2. Verfahren nach Anspruch 1,
**dadurch gekennzeichnet , daß** vor dem Polieren auf die leitende Schicht (14) eine Füllschicht (15) aufgebracht wird.

3. Verfahren nach einem der vorherstehenden Ansprüche,
**dadurch gekennzeichnet , daß** nach dem Polieren eine Deckschicht (16), insbesondere eine isolierende Deckschicht aufgebracht wird.

4. Verfahren nach einem der vorherstehenden Ansprüche,
**dadurch gekennzeichnet , daß** die Maske (12) zumindest zwei Schichten (9, 11) umfaßt.

5. Verfahren nach einem der vorherstehenden Ansprüche,
**dadurch gekennzeichnet , daß** das Material der dielektrischen Schicht (13) ein Dielektrikum mit einer hohen Dielektrizitätskonstante, ein Ferroelektrikum und/oder die Vorstufe eines Ferroelektrikums enthält.

6. Verfahren nach Anspruch 5,
**dadurch gekennzeichnet , daß** das Material der dielektrischen Schicht (13) SBT, PZT oder BST enthält.

7. Verfahren nach einem der vorherstehenden Ansprüche,
**dadurch gekennzeichnet , daß** das Material der leitenden Schicht (14) ein Edelmetall, insbesondere Pt oder Ir, oder ein Oxid eines Edelmetalls enthält.

8. Verfahren nach einem der vorherstehenden Ansprüche,
**dadurch gekennzeichnet , daß** das Polieren als CMP-Prozeß durchgeführt wird.

9. Verfahren nach Anspruch 8,
**dadurch gekennzeichnet , daß** für jede zu polierende Schicht ein an die zu polierende Schicht angepaßter CMP-Schritt durchgeführt wird.

10. Verfahren nach einem der vorherstehenden Ansprüche,
**dadurch gekennzeichnet, daß** die erste Elektrode (10) ein Edelmetall, insbesondere Pt oder Ir, oder ein leitendes Oxid eines Edelmetalls enthält.

11. Verfahren nach einem der vorherstehenden Ansprüche,
**dadurch gekennzeichnet , daß** die erste Elektrode (10) erzeugt wird, indem eine leitende Schicht (10) aufgebracht und durch Polieren strukturiert wird.

12. Verfahren nach Anspruch 11,
**dadurch gekennzeichnet , daß** die leitende Schicht (10) für die erste Elektrode (10) konform aufgebracht wird.

13. Verfahren nach einem der vorherstehenden Ansprüche,
**dadurch gekennzeichnet , daß** die dielektrische Schicht (13) und die leitende Schicht (14) für die zweite Elektrode konform aufgebracht werden.

14. Verfahren nach einem der vorherstehenden Ansprüche,
**dadurch gekennzeichnet , daß** die dielektrische Schicht (13) durch ein CVD-Verfahren aufgebracht wird.

## Claims

1. A method for producing at least one capacitor structure, including the following steps in the specified order:
(a) a substrate (1) is provided,
(b) at least a first electrode (10) is produced on the substrate (1),
(c) a mask (12) is produced, wherein the first electrode (10) is positioned in an opening of the mask (12),
(d) at least one dielectric layer (13) and at least one conductive layer (14) for a second electrode are applied, wherein the surface (14A) of the conductive layer's (14) portion being applied within the opening of the mask (12) is substantially disposed below the surface (12A) of the mask (12), and
(e) the conductive layer (14) and the dielectric layer 13 are removed from the surface (12A) of the mask (12) by polishing so that a capacitor structure is produced.

2. The method of claim 1,
**characterized in that** a filling layer (15) is applied onto the conductive layer (14) prior to polishing.

3. The method of any of the preceding claims,
**characterized in that** a top layer (16), especially an insulating top layer, is applied.

4. The method of any of the preceding claims,
**characterized in that** the mask (12) comprises at least two layers (9, 11).

5. The method of any of the preceding claims,
**characterized in that** the material of the dielectric layer (13) comprises a dielectric material having a dielectric constant, a ferroelectric material and/or a precursor material of a ferroelectric material.

6. The method of claim 5,
**characterized in that** the material of the dielectric layer (13) comprises SBT, PZT, or BST.

7. The method of any of the preceding claims,
**characterized in that** material of the conductive layer (14) comprises a noble metal, especially Pt or Ir, or an oxide of a noble metal.

8. The method of any of the preceding claims,
**characterized in that** the polishing is carried out as a CMP process.

9. The method of claim 9,
**characterized in that** a CMP step adapted to the layer to be polished is carried out for each layer to be polished.

10. The method of any of the preceding claims,
**characterized in that** the first electrode (10) comprises a noble metal, especially Pt or Ir, or a conductive oxide of a noble metal.

11. The method of any of the preceding claims,
**characterized in that** the first electrode (10) is produced by applying a conductive layer (10) and structuring it by polishing.

12. The method of claim 11,
**characterized in that** the conductive layer (10) for the first electrode (10) is conformally deposited.

13. The method of any of the preceding claims,
**characterized in that** the dielectric layer (13) and the conductive layer (14) for the second electrode are conformally deposited.

14. The method of any of the preceding claims,
**characterized in that** the dielectric layer (13) is deposited by a CVD process.

## Revendications

1. Procédé de fabrication d'au moins une structure de condensateur, comportant les étapes suivantes dans l'ordre indiqué :
a) on met à disposition un substrat (1),
b) on génère au moins une première électrode (10) sur le substrat,
c) on génère un masque (12), suite à quoi la première électrode (10) est disposée dans une ouverture du masque (12),
d) on applique au moins une couche diélectrique (13) et au moins une couche conductrice (14) pour une seconde électrode, suite à quoi la surface (14A) de la partie de la couche conductrice (14) qui est appliquée dans l'ouverture du masque (12) est disposée essentiellement sous la surface (12A) du masque (12), et
e) par polissage, on enlève la couche conductrice (14) et la couche diélectrique (13) de la surface (12A) du masque (12), si bien qu'une structure de condensateur est générée.

2. Procédé selon la revendication 1, **caractérisé en ce qu'**avant le polissage, on applique sur la couche conductrice (14) une couche de remplissage (15).

3. Procédé selon l'une des revendications précédentes, **caractérisé en ce qu'**après le polissage, on applique une couche de surface (16), en particulier une couche de surface isolante.

4. Procédé selon l'une des revendications précédentes, **caractérisé en ce que** le masque (12) comprend au moins deux couches (9, 11).

5. Procédé selon l'une des revendications précédentes, **caractérisé en ce que** le matériau de la couche diélectrique (13) contient un diélectrique qui présente une constante diélectrique élevée, un ferro-électrique et/ou le précurseur d'un ferro-électrique.

6. Procédé selon la revendication 5, **caractérisé en ce que** le matériau de la couche diélectrique (13) contient SBT, PZT ou BST.

7. Procédé selon l'une des revendications précédentes, **caractérisé en ce que** le matériau de la couche conductrice (14) contient un métal noble, en particulier Pt ou Ir, ou un oxyde d'un métal noble.

8. Procédé selon l'une des revendications précédentes, **caractérisé en ce que** le polissage est réalisé en tant que procédé CMP.

9. Procédé selon la revendication 8, **caractérisé en ce que** pour chaque couche à polir, on réalise une étape CMP adaptée à la couche à polir.

10. Procédé selon l'une des revendications précédentes, **caractérisé en ce que** la première électrode (10) contient un métal noble, en particulier Pt ou Ir, ou un oxyde conducteur d'un métal noble.

11. Procédé selon l'une des revendications précédentes, **caractérisé en ce que** l'on génère la première électrode (10) **en ce que** l'on applique une couche conductrice (10) et que l'on structure par polissage.

12. Procédé selon la revendication 11, **caractérisé en ce que** la couche conductrice (10) est appliquée de façon conforme pour la première électrode (10).

13. Procédé selon l'une des revendications précédentes, **caractérisé en ce que** la couche diélectrique (13) et la couche conductrice (14) sont appliquées de façon conforme pour la seconde électrode.

14. Procédé selon l'une des revendications précédentes, **caractérisé en ce que** la couche diélectrique (13) est appliquée par un procédé CVD (de dépôt chimique en phase vapeur).
